# EUROPEAN PATENT APPLICATION

(11) **EP 4 113 598 A2**
(43) Date of publication of application: **04.01.2023**
(21) Application number: 22181496.5
(22) Date of filing: 28.06.2022
(51) Int. Cl.: H01L 23/485, H01L 23/00, H01L 23/31, H01L 21/60

(54) **INTEGRATED ELECTRONIC DEVICE WITH A PAD STRUCTURE INCLUDING A BARRIER STRUCTURE AND RELATED MANUFACTURING PROCESS**

(30) Priority: 29.06.2021 IT 202100017021
(71) Applicant: STMicroelectronics S.r.l., 20864 Agrate Brianza (MB) (IT)
(72) Inventor: DORIA, Daria, 22100 Como (IT)
(74) Representative: Studio Torta S.p.A.

(57) **Abstract**

An integrated electronic device including: a main body (2) delimited by a front surface (Sₜₒₚ); a top conductive region (10) extending within the main body (2), starting from the front surface (Sₜₒₚ); a first dielectric region (14) extending on the front surface (Sₜₒₚ); and a barrier structure (35), arranged on the first dielectric region (14). A first aperture (50) extends through the barrier structure (35) and the first dielectric region (14); the first aperture (50) is delimited at bottom by the top conductive region (10). The integrated electronic device (31) further includes a contact structure (22) including at least a first conductive region (24) extending within the first aperture (50), in direct contact with the top conductive region (10) and the barrier structure (35).

## Description

The present invention refers to an integrated electronic device with a pad structure including a barrier structure and to the related manufacturing process.

As it is known, nowadays several types of integrated electronic devices are available; as an example, integrated electronic devices are known which include, each, a corresponding high-voltage passive electronic component, such as a capacitor or an inductor, or a corresponding active electronic component, such as a transistor.

In addition, the integrated electronic devices include contact structures known as pads ("piazzole"), which allow to put the integrated electronic device in ohmic contact with the external world.

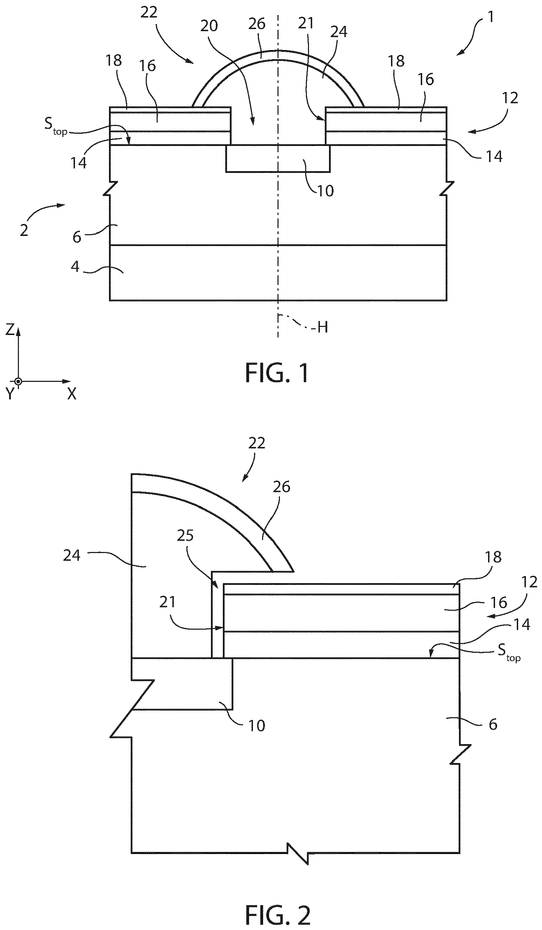

As an example, Figure 1 shows an integrated electronic device 1, which includes a main body 2 delimited at top by a front surface Sₜₒₚ. The main body 2 comprises a semiconductive substrate 4 and a top region 6, which may include a number of dielectric layers (not shown) and a number of metallization layers (not shown); in addition, the top region 6 is delimited at top by the front surface Sₜₒₚ.

The integrated electronic device 1 further includes a top conductive region 10, formed, as an example, by copper; the top conductive region 10 extends within the top region 6, starting from the front surface Sₜₒₚ. Though not shown, in top view the top conductive region 10 may have a circular shape; in addition, the top conductive region 10 may belong to the so-called top metallization level of the integrated electronic device 1. In a per se known manner, the top conductive region 10 is in electric contact with the electronic component formed within the integrated electronic device 1.

In addition, the integrated electronic device 1 includes a passivation structure 12, which includes, as an example, a first dielectric region 14, which is made of silicon nitride and is arranged on the front surface Sₜₒₚ, in direct contact with the top region 6 and with a peripheral portion of the top conductive region 10.

The passivation structure 12 further includes a second dielectric region 16, which is made of TEOS oxide and is arranged on the first dielectric region 14, in direct contact. In addition, the passivation structure 12 further includes a third dielectric region 18, which is made of silicon nitride and is arranged on the second dielectric region 16, in direct contact.

An aperture 20 extends through the first, second and third dielectric regions 14, 16, 18; though not shown, in top view the aperture 20 may have a circular shape. The aperture 20 is delimited at bottom by an inner portion of the top conductive region 10; furthermore, the aperture 20 is laterally delimited by a side wall 21, which, to a first approximation, has a cylindrical shape and is formed by portions of the first, second and third dielectric regions 14, 16, 18.

The integrated electronic device 1 further includes a contact structure 22, which in turn includes a first and a second conductive contact region 24, 26.

In detail, the first conductive contact region 24 is made of nickel. The first conductive contact region 24 includes a lower portion, which extends within the aperture 20, in direct contact with the underlying inner portion of the top conductive region 10 and with the side wall 21, and an upper portion, which extends outside the aperture 20, above the abovementioned lower portion and on a portion of the third dielectric region 18 that surrounds the upper part of the aperture 20. By adopting an orthogonal reference system XYZ such that the plane XY is parallel to the front surface Sₜₒₚ, to a first approximation the thickness (parallel to the Z axis) of the upper portion of the first conductive contact region 24 decreases as the radial distance from an axis H (parallel to Z axis) increases. To a first approximation, the axis H is a symmetry axis of the first conductive contact region 24, which has a mushroom-like shape.

The second conductive contact region 26 is made of palladium and extends on the first conducive contact region 24, in direct contact and approximately with a constant thickness, i.e. in a conformal manner. In particular, an inner portion of the second conductive contact region 26 extends on the first conductive contact region 24; an outer portion of the second conductive contact region 26 extends on a portion of the third dielectric region 18.

Though not shown, the second conductive contact region 26 is connected to the external world, as an example through a wire bonding, i.e. by welding a conductive wire (not shown) to the second conductive contact region 26.

From a practical point of view, the contact structure 22 and the top conductive region 10 form a so-called pad, which allows to set an electric contact between the integrated electronic device 1 and the external world. However, such a pad may by prone to the phenomenon of the corrosion of the top conductive region 10, for the following reasons.

The abovementioned first and second conductive contact regions 24, 26 of the contact structure 22 are formed by means of electroless deposition; such a technique allows to form conductive regions on top of an underlying pre-existing conductive support and causes the contact structure to have the abovementioned mushroom-like shape. However, as shown in Figure 2, it may happen that a crevice ("fenditura") 25 occurs between the contact structure 22 and the passivation structure 12. In particular, the crevice 25 may extend between the lower portion of the first conductive contact region 24 and the side wall 21, as well as between the upper portion of the first conductive contact region 24 and the abovementioned portion of the third dielectric region 18 surrounding the upper part of the aperture 20; in addition, the crevice 25 may extend between the second conductive contact region 26 and an underlying portion of the third dielectric region 18.

The crevice 25 is delimited at bottom by an exposed portion of the top conductive region 10; therefore, the crevice 25 forms a path through which contaminants (as an example, made of metals or halogens such as chlorine and fluorine) can come into contact with the top conductive region 10, thereby causing an unwanted corrosion of this latter, and thus damaging the pad.

The aim of the present invention is consequently to provide a pad structure for an integrated electronic device, that will enable the drawbacks of the prior art to be overcome at least in part.

According to the present invention, an integrated electronic device and a corresponding manufacturing process are provided, as defined in the annexed claims.

For a better understanding of the present invention, preferred embodiments thereof are now described, purely by way of non-limiting example, with reference to the attached drawings, wherein:
- Figure 1 is a schematic cross-sectional view (not in scale) of a portion of an integrated electronic device;
- Figure 2 is a schematic cross-sectional view (not in scale) of a portion of an integrated electronic device subjected to a crevice;
- Figure 3 is a schematic cross-sectional view (not in scale) of the present integrated electronic device;
- Figure 4 is a schematic top plan view of a portion of the integrated electronic device shown in Figure 3;
- Figures 5-10 are schematic cross-sectional views (not in scale) of portions of an integrated electronic device, in successive manufacturing steps; and
- Figure 11 is a schematic cross-sectional view (not in scale) of a variant of the present integrated electronic device.

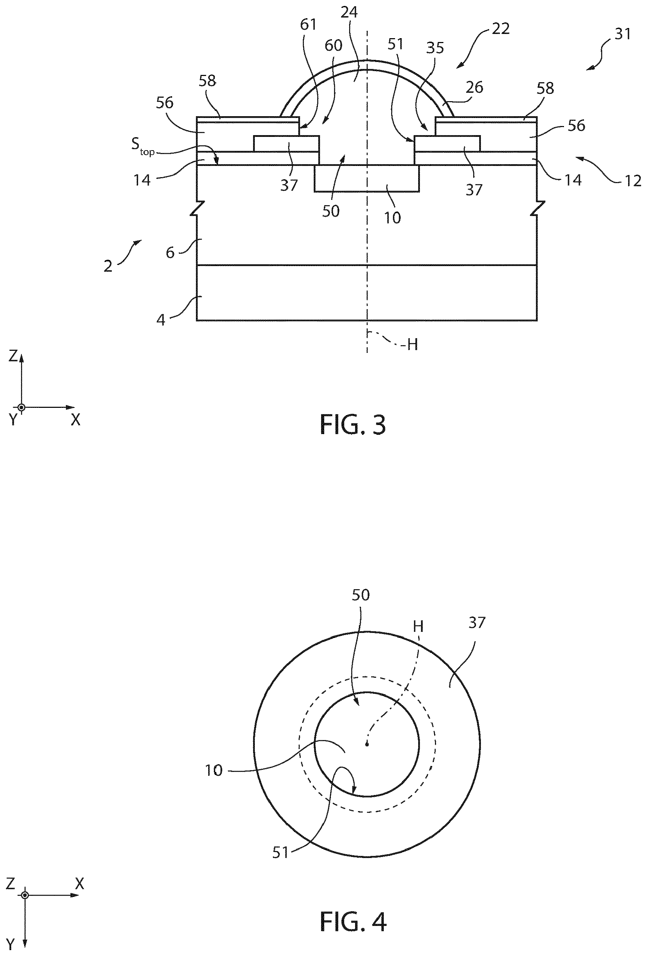

Figure 3 shows an integrated electronic device 31, which will be described here below with reference to the differences with respect to the integrated electronic device 1 shown in Figure 1. Elements already present in the integrated electronic device 1 shown in Figure 1 will have the same reference signs, unless otherwise stated.

In detail, the integrated electronic device 31 includes a barrier structure 35, which includes a first barrier region 37. Furthermore, the first barrier region 37 is made of a material that prevents the migration/diffusion of contaminants (such as metals or halogens); as an example, the first barrier region 37 may be made of tungsten-titanium.

In greater detail, the first barrier region 37 is arranged on the first dielectric region 14, in direct contact. As an example, as shown in Figure 4, in top view the first barrier region 37 has the shape of an annulus.

In addition, the first barrier region 37 and the first dielectric region 14 form the side wall (here designated by 51) of the aperture (here designated by 50), to which in the following reference will be made as the first aperture 50. Furthermore, in the following reference will be made to the side wall 51 as the first side wall 51.

In practice, the first aperture 50 extends through the first dielectric layer 14 and the first barrier region 37; furthermore, the first aperture 50 has a cylindrical shape.

The second dielectric region (here designated by 56) extends on the first barrier region 37, in direct contact, as well as on portions of the first dielectric region 14 laterally offset with respect to the first barrier region 37. The third dielectric region (here designated by 58) extends on the second dielectric region 56, in direct contact.

A second aperture 60 extends through the second and the third dielectric region 56, 58 and communicates with the underlying first aperture 50. The second aperture 60 may have a cylindrical shape, vertically aligned with the underlying first aperture 50 and with a circular base greater than the circular base of the first aperture 50, so that a peripheral portion of the second aperture 60 is delimited at bottom by a portion of the first barrier region 37 that surrounds the first aperture 50, and an inner portion of the second aperture 60 overlies the first aperture 50. The second aperture 60 is laterally delimited by a corresponding side wall designated by 61, to which reference will be made as the second side wall 61; the second side wall 61 is formed by the second and the third dielectric region 56, 58.

The lower portion of first conductive contact region 24 extends within the first and the second aperture 50, 60; the upper portion of the first conductive contact region 24 extends outside the second aperture 60, above the abovementioned lower portion and on a portion of the third dielectric region 58 that surrounds the upper part of the second aperture 60, with a thickness (parallel to the Z axis) that, to a first approximation, decreases as the radial distance from the axis H increases. The second conductive contact region 26 still extends on the first conductive contact region 24, in direct contact.

In greater detail, the lower portion of first conductive contact region 24 contacts either the abovementioned portion of the first barrier region 37 that delimits the peripheral portion of the second aperture 60 at bottom and the portion of the first side wall 51 formed by the first barrier region 37, with which it forms a strong bond, little prone to the phenomenon of crevice.

In practice, even if in use a crevice may occur between the second side wall 61 and the lower portion of first conductive contact region 24, such a crevice is closed at bottom by the barrier structure 35, because of the strong bond present between the first conductive contact region 24 and the first barrier region 37. Since the first barrier region 37 acts as a stopper region for the contaminants, these latter cannot come into contact with the top conductive region 10, which is thus protected from corrosion.

The integrated electronic device 31 can be manufactured through the manufacturing process described here below.

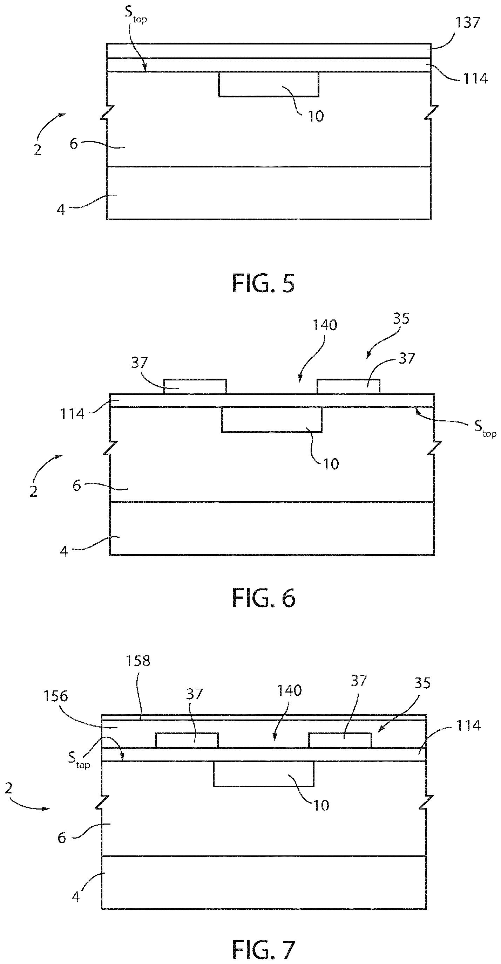

In detail, after forming in a per se known manner the main body 2 and the top conductive region 10, a first dielectric layer 114 of silicon nitride is formed on the front surface Sₜₒₚ, as shown in Figure 5; in addition, a conductive layer 137 is formed, on top of the first dielectric layer 114, as an example by physical vapor deposition (PVD). The conductive layer 137 is made of tungsten-titanium. In addition, the dielectric layer 114 acts as a "capping layer", which prevents the corrosion of the underlying top conductive region 10.

As shown in Figure 6, portions of the conductive layer 137 are then selectively removed, as an example by means of dry or wet etch, so that the remaining portion of the conductive layer 137 forms the first barrier region 37, and thus the barrier structure 35.

In particular, the first barrier region 37 laterally delimits a window 140, delimited at bottom by the first dielectric layer 114 and overlying, at a distance, the top conductive region 10; in addition, the first barrier region 37 leaves exposed portions of the first dielectric layer 114 that are laterally offset with respect to the first barrier region 37.

Afterwards, as shown in Figure 7, a second dielectric layer 156 of TEOS oxide is formed on the exposed portions of the first dielectric layer 114, on the first barrier region 37 and within the window 140; in addition, a third dielectric layer 158 of silicon nitride is formed on the second dielectric layer 156.

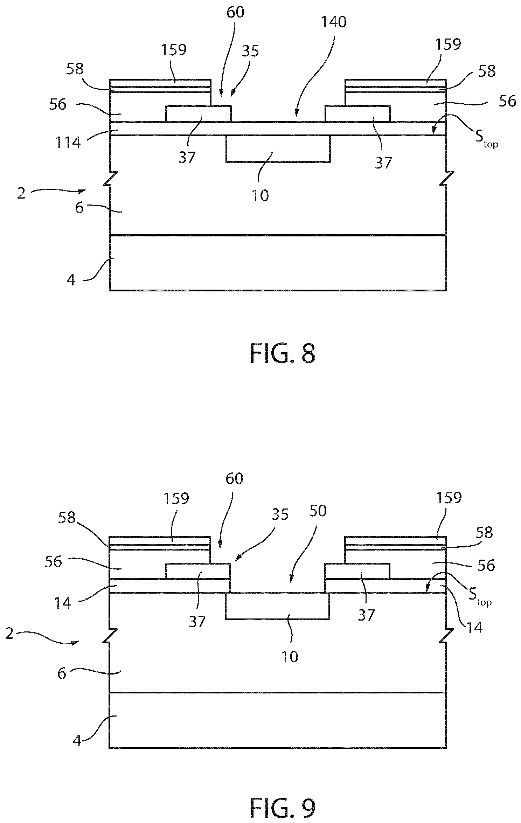

Afterwards, as shown in Figure 8, a portion of the third dielectric layer 158 and an underlying portion of the second dielectric layer 156 are selectively removed, as an example by means of a dry etch, which is performed through a mask 159 arranged on the third dielectric layer 158. In such a way, the second aperture 60 is formed, through the second and the third dielectric layer 156, 158; in addition, the portion of the second dielectric layer 156 that extends within the window 140 is removed, so that the portion of the first dielectric layer 114 that delimits the window 140 at bottom is exposed. In addition, this etch cause the exposure of a portion of the barrier region 37 that delimits the second aperture 60 at bottom and laterally delimits the window 140. The remaining portions of the second and the third dielectric layer 156, 158 respectively form the second and the third dielectric region 56, 58.

Afterwards, as shown in Figure 9, by keeping in place the mask 159, a further selective etch is performed, so as to selectively remove the portion of the first dielectric layer 114 arranged under the window 140, thereby exposing the inner portion of the top conductive region 10 and forming the first aperture 50. The remaining portion of the first dielectric layer 114 forms the first dielectric region 14.

From a practical point of view, this etch, which is based on a chemistry different from the one of the etch shown in Figure 8, is guided by the first barrier region 37, along with the mask 159.

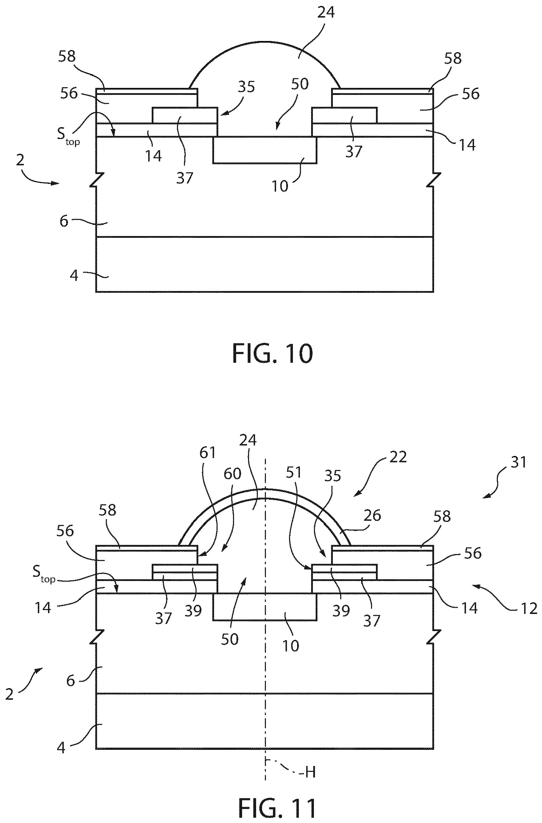

Afterwards, as shown in Figure 10, the mask 159 is removed and the first conductive contact region 24 is formed by electroless deposition, starting from the exposed inner portion of the top conductive region 10 and from the exposed portion of the barrier region 37.

Afterwards, although not shown, the second conductive contact region 26 is formed by electroless deposition, on the first conductive contact region 24.

The manufacturing process of the integrated electronic device 31 may then continue in a per se known manner, as an example by forming a further protection region (not shown).

The advantages of the present solution emerge clearly from the foregoing description. In this connection, it should again be noted how, according to the present solution, the top conductive region 10 is protected from corrosion, because the barrier structure 35 acts as a stopper structure that is tightly bonded to the first conductive contact region 24, thereby leading to an improved pad structure.

Finally, it is clear that modifications and variations may be made to what has been described and illustrated herein, without thereby departing from the scope of the present invention, as defined in the annexed claims.

In general, the materials may be different from the previously cited ones.

The passivation structure may be formed by a different number of dielectric regions (as an example, only one region or more than two regions). As an example, the third dielectric region 58 may be absent.

Similarly, the first barrier region 37 may have a different shape; as an example, in top view, the first barrier region 37 may have the shape of a polygonal frame ("cornice"). In addition, the first barrier region 37 may be formed by a conductive material different from tungsten-titanium.

Furthermore, the barrier structure 35 may be formed by a stack of two or more barrier regions made of conductive materials that prevent the migration/diffusion of the contaminants. As an example, the barrier structure 35 may be formed by one of the following barrier region stacks: TaNTa (two barrier regions), TiN (one barrier region), TiTiN (two barrier regions) or TiTiNTi (three barrier regions). In this case, the first aperture 50 extends through the stack of barrier regions.

As an example, Figure 11 shows an example in which the barrier structure 35 includes a second barrier region 39, which is arranged on the first barrier region 37, in direct contact. In top view, the second barrier region 39 may have the same shape as the underlying first barrier region 37; the first aperture 50 extends through the first and the second barrier region 37, 39. In this example, the first and the second barrier region 37, 39 are respectively made of titanium and titanium nitride. Furthermore, the first and the second barrier region 37, 39 are vertically aligned and form corresponding portions of the first side wall 51. In this case, the peripheral portion of the second aperture 60 is delimited at bottom by a portion of the second barrier region 39; the lower portion of first conductive contact region 24 contacts either the portion of the barrier region 39 that delimits the peripheral portion of the second aperture 60 at bottom and the portions of the first side wall 51 formed by the first and the second barrier region 37, 39, with which it forms a strong bond.

The first and the second conductive contact region 24, 26 may be formed by materials different from nickel and palladium. In addition, the second conductive contact region 26 may be absent, in which case the wire bonding is welded on the first conductive contact region 24; as an alternative, one or more additional conductive contact regions may be formed on the second conductive contact region 26. As an example, the contact structure 22 may be formed by the stack NiPdAu, i.e. by three conductive contact regions.

The shapes of the first and the second aperture 50, 60 may be different; as an example, in top view, either of them may have a polygonal shape. Therefore, in top view, also the first and the second side wall 51, 61 may have, as an example, a polygonal shape.

The top conductive region 10 may be made of a material different from copper. In addition, the top conductive region 10 may have a different shape; as an example, in top view, the top conductive region 10 may have a polygonal shape.

The inner portion of the top conductive region 10, which delimits the first aperture 50 at bottom, may be slightly overetched with respect to the peripheral portion of the top conductive region 10, which lies under the first dielectric region 14.

## Claims

1. An integrated electronic device including:
- a main body (2) delimited by a front surface (Sₜₒₚ);
- a top conductive region (10) extending within the main body (2), starting from the front surface (Sₜₒₚ);
- a first dielectric region (14) extending on the front surface (Sₜₒₚ); and
- a barrier structure (35), arranged on the first dielectric region (14);
and wherein a first aperture (50) extends through the barrier structure (35) and the first dielectric region (14), said first aperture (50) being delimited at bottom by the top conductive region (10); said integrated electronic device (31) further comprising a contact structure (22) including at least a first conductive region (24) extending within the first aperture (50), in direct contact with the top conductive region (10) and the barrier structure (35).

2. The integrated electronic device according to claim 1, wherein the barrier structure (35) includes a stack of one or more barrier regions (37,39) made of one or more conductive materials suitable for preventing the diffusion of metal and halogen contaminants through the barrier structure (35).

3. The integrated electronic device according to claim 2, wherein said one or more barrier regions (37,39) are made of conductive materials different from the materials of the top conductive region (10) and of the first conductive region (24) .

4. The integrated electronic device according to any of the preceding claims, further comprising a second dielectric region (56,58) extending on the barrier structure (35); and wherein a second aperture (60) extends through the second dielectric region (56,58), said second aperture (60) having a respective inner portion, which communicates with the underlying first aperture (50), and a respective peripheral portion, which is delimited at bottom by a portion of the barrier structure (35); and wherein the first conductive region (24) extends also within the second aperture (60), on said portion of the barrier structure (35).

5. The integrated electronic device according to claim 4, wherein the first conductive region (24) extends also above the second aperture (60) and has a mushroom-like shape.

6. The integrated electronic device according to any of the preceding claims, wherein the contact structure (22) further comprises a second conductive region (26) extending on the first conductive region (24), the first and the second conductive region (24,26) being respectively made of nickel and palladium.

7. A process for manufacturing an integrated electronic device, comprising:
- forming a main body (2) delimited by a front surface (Sₜₒₚ);
- forming a top conductive region (10) extending within the main body (2), starting from the front surface (Sₜₒₚ);
- forming a first dielectric region (14) on the front surface (Sₜₒₚ); and
- forming a barrier structure (35) on the first dielectric region (14);
- forming a first aperture (50) through the barrier structure (35) and the first dielectric region (14), said first aperture (50) being delimited at bottom by the top conductive region (10); and
- forming a contact structure (22) including at least a first conductive region (24) extending within the first aperture (50), in direct contact with the top conductive region (10) and the barrier structure (35).

8. The manufacturing process according to claim 7, further comprising forming a first dielectric layer (114) on the front surface (Sₜₒₚ) and forming said barrier structure (35) on the first dielectric layer (114), so that the barrier structure (35) laterally delimits a window (140) closed at bottom by the first dielectric layer (114); said manufacturing process further including:
- forming at least a second dielectric layer (156) extending on the barrier structure (35) and within the window (140) ;
- through a temporary mask (159), selectively removing portions of said second dielectric layer (156) that extend on the barrier structure (35) and within the window (140), so as to form a second aperture (60) extending through the second dielectric layer (156), said second aperture (60) having a respective inner portion, which communicates with the underlying window (140), and a respective peripheral portion, which is delimited at bottom by a portion of the barrier structure (35); and then
- through said temporary mask (159), selectively removing the portion of the first dielectric layer (114) that closes the window (140) at bottom, so as to form said first aperture (50).

9. The manufacturing process according to claims 7 or 8, comprising forming said first conductive region (24) by electroless deposition.

10. The manufacturing process according to claim 9, further comprising forming, by electroless deposition, a second conductive region (26) on the first conductive region (24).

11. The manufacturing process according to any of claims 7-10, wherein the barrier structure (35) includes a stack of one or more barrier regions (37,39) made of one or more conductive materials suitable for preventing the diffusion of metal and halogen contaminants through the barrier structure (35).
